# EUROPÄISCHE PATENTANMELDUNG

(11) **EP 0 828 013 A2**
(43) Veröffentlichungstag der Anmeldung: **11.03.1998**
(21) Anmeldenummer: 97115249.1
(22) Anmeldetag: 02.09.1997
(51) Int. Cl.: C23C 16/26, C23C 16/44, C23C 16/02

(54) **Verfahren zum Beschichten eines Trägers mit Diamant**

(30) Priorität: 09.09.1996 DE 19636525; 01.08.1997 EP 97113331
(71) Anmelder: Werdecker, Waltraud, 63456 Hanau (DE)
(72) Erfinder: Werdecker, Waltraud, 63456 Hanau (DE)

(57) **Zusammenfassung**

Es ist ein Verfahren zur Beschichtung eines Trägers mit einer Oberflächenschicht aus synthetischer Diamantphase durch Bereitstellen und Einbringen des Trägers in eine kohlenstoffhaltige, im angeregten Zustand befindliche Gasphase und Abscheiden einer Oberflächenschicht aus synthetischer Diamantphase auf dem Träger bekannt, wobei eine Vielzahl partikelförmig ausgebildeter Träger aufgeschüttet werden und die Träger während der Abscheidung einer allseitig geschlossenen Oberflächenschicht, einer translatorischen und einer Rotationsbewegung ausgesetzt werden. Um hiervon ausgehend ein Verfahren bereitzustellen, das die ökonomische Herstellung eines allseitig mit Diamantphase beschichteter Träger mit verbesserten und homogeneren Eigenschaften erlaubt, wird erfindungsgemäß vorgeschlagen, daß die Träger sphärisch ausgebildet sind und eine spezifische Oberfläche von mindestens 0,5 m²/g aufweisen.

Weiterhin ist ein Komposit aus einem Träger mit einer Oberflächenschicht aus synthetischer Diamantphase bekannt, wobei der Träger partikelförmig ausgebildet ist und allseitig mit einer Oberflächenschicht aus synthetischer Diamantphase versehen ist.
Um hiervon ausgehend ein Komposit bereitzustellen, das als verbesserter, wärmeleitender Füllstoff oder kostengünstiges Läpp- und Poliermittel einsetzbar ist, das in verkürzter Zeit zu hohen Oberflächengüten der bearbeiteten Werkstücke führt und weiterhin in Form seiner Schüttung als Hilfsstoff zur Diamantbeschichtung kleiner Formteile, zur Vergrößerung von stückigen Diamanten oder zur Beschichtung von Schmucksteinen, geeignet ist, wird zur Lösung der Aufgabe erfindungsgemäß vorgeschlagen, daß der Träger sphärisch ausgebildet ist und eine spezifische Oberfläche von wenigstens 0,5 m²/g aufweist.

## Beschreibung

Die vorliegende Erfindung betrifft ein Verfahren zur Beschichtung eines Trägers mit einer Oberflächenschicht aus synthetischer Diamantphase durch Bereitstellen eines Trägers, Einbringen des Trägers in eine kohlenstoffhaltige, im angeregten Zustand befindliche Gasphase und Abscheiden einer Oberflächenschicht aus synthetischer Diamantphase auf einem Träger, wobei eine Vielzahl partikelförmig ausgebildeter Träger aufgeschüttet werden und die Träger während der Abscheidung einer allseitig geschlossenen Oberflächenschicht, einer translatorischen und einer Rotationsbewegung ausgesetzt werden.

Weiterhin betrifft die Erfindung ein Komposit aus einem Träger mit einer Oberflächenschicht aus synthetischer Diamantphase, wobei der Träger partikelförmig ausgebildet ist und allseitig mit einer Oberflächenschicht aus synthetischer Diamantphase versehen ist.

Die Erfindung betrifft außerdem eine geeignete Anwendung des so hergestellten Komposit-Materials.

In der Schrift DE-OS 35 46 113 werden Verbundpulverteilchen und ein Verfahren zur Herstellung von Verbundpulverteilchen beschrieben, wobei als innerer Kern ein- oder polykristalline Partikel verwendet werden, die aus gegenüber Kohlenstoff bis zu 1000°C inerten Hartstoffteilchen oder aus Teilchen normaler Härte bestehen, die ebenfalls bis 1000°C gegenüber Kohlenstoff inert sind. Die Partikel werden in eine kohlenstoffhaltige, angeregte Gasphase eingebracht und während der ganzflächigen Diamantabscheidung in einem Wirbelbett translatorischer und Rotationsbewegung ausgesetzt. Die Verbundpulverteilchen können für Polier- und Schleifzwecke verwendet werden.

Der Erfindung liegt die Aufgabe zugrunde, ein ökonomisches Verfahren anzugeben, das die Herstellung allseitig mit Diamantphase beschichteter Träger mit verbesserten und homogeneren Eigenschaften ermöglicht, sowie ein Komposit bereitzustellen, das als verbesserter wärmeleitender Füllstoff oder kostengünstiges Läpp- und Poliermittel, das in verkürzter Zeit zu hohen Oberflächengüten der bearbeiteten Werkstücke führt, einsetzbar ist. Eine weitere Aufgabe der Erfindung ist die Bereitstellung einer Schüttung, die als Hilfsstoff zur Diamantbeschichtung kleiner Formteile, zur Vergrößerung von stückigen Diamanten oder zur Beschichtung von Schmucksteinen, geeignet ist.

Die oben genannte Aufgabe wird hinsichtlich des Verfahrens erfindungsgemäß dadurch gelöst, daß sphärisch ausgebildete Trägerteilchen, die eine spezifische Oberfläche von wenigstens 0,5 m²/g aufweisen, der kohlenstoffhaltigen, angeregten Gasphase zur Diamantbeschichtung ausgesetzt werden. Die sphärische Ausbildung des partikelförmigen Trägers läßt eine sehr homogene Beschichtung des Trägers mit Diamantphase zu. Kanteneffekte, die sich bei unregelmäßig geformten Trägerteilchen durch unterschiedliche Dicken in der Beschichtung bemerkbar machen, können vollständig vermieden werden. Die Endgröße und Geometrie des beschichteten Trägers läßt sich damit sehr genau einstellen, da sich die Geometrie des Trägers in der Geometrie des diamantbeschichteten Komposit-Teilchens wiederzpiegelt. Die spezifische Oberfläche des Trägers von wenigstens 0,5 m²/g nimmt dabei eine verfahrenstechnische Schlüsselrolle ein. Die bevorzugte spezifische Oberfläche ist größer als 2 m²/g. Es läßt sich damit ein ökonomischer Abscheideprozeß realisieren. Es kommen Nano-Teilchen oder µm-Teilchen sphärischer Ausprägung, wie sie typischerweise aus Sol/Gel- oder Pyrolyse-Verfahren gewonnen werden, zum Einsatz. Nano-Teilchen sind häufig röntgenamorph und weisen eine spezifische Oberfläche von wenigstens 20 m²/g auf. Durch Einbringen von Trägern einer hoher spezifischen Oberfläche lassen sich gegenüber Trägern mit normaler spezifischer Oberfläche (< 0,5 m²/g) bei ansonsten gleichbleibenden Prozeßbedingungen die Abscheideraten, in Karat pro Zeiteinheit gegenüber herkömmlicher Vorgehensweise, um ein Vielfaches erhöhen.

Unter dem Begriff 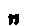 Diamantphase" wird im Folgenden synthetisch hergestellter Kohlenstoff in sp³-Bindung und weiterhin Kohlenstoff, der sp²-Bindungsanteil aufweist und unter der Bezeichnung DLC ( diamond like carbon ) bekannt ist, verstanden.

Nach einer bevorzugten Verfahrensweise werden die Träger mittels Sprühgranulation hergestellt, bei der unter Beibehaltung der spezifischen Oberfläche der Primärteilchen, sphärische Granulate mit durchgehenden Porenkanälen gebildet werden. Es können jedoch auch andere Granulationstechniken angewendet werden, die zu sphärischen Granulaten unter Beibehaltung der spezifischen Oberfläche führen. Die bevorzugte Granulationstechnik ist die Sprühtrocknung, insbesondere die Zentrifugalzerstäubung, mit deren Hilfe es gelingt, aus extrem feinteiligen Pulvern oder Stäuben sphärische Granulate definiter Abmessungen mit homogener Porenverteilung zu erzeugen, wie es mit einem anderen Verfahren kaum möglich ist. Es können Sprühgranulate mit Granulatgrößen zwischen 5 und 600 µm verwendet werden, bei denen verfahrensbedingt ein enges Korngrößenspektrum einstellbar ist. Die als Träger bevorzugt verwendeten Granulate weisen einen Durchmesser von 10 bis 400 µm auf. Als Primärteilchen kommen Nano-Pulver oder µm-Pulver, bevorzugt sphärischer Ausprägung zu Einsatz, wie sie typischerweise aus Sol/Gel-Verfahren oder Pyrolyse-Verfahren gewonnen werden. Es lassen sich auch Teilchen mit splittriger oder ideomorpher Ausprägung mittels Sprühgranulation zu Trägern sphärischer Ausprägung unter Beibehaltung der spezifischen Oberflächevon wenigstens 0,5 m²/g umgestalten. Ein großer Teil der äußeren Oberfläche befindet sich dann in Form von Porenwandungen auf der Innenoberfläche der Träger. Eine thermische Verfestigung des als Sprühgranulat ausgebildeten Trägers, macht ihn abriebbeständiger, was vorallem in der Anfangsphase der Beschichtung von Vorteil ist, wenn die Porenkanäle noch nicht mit Diamantphase geschlossen sind.

Es hat sich als vorteilhaft erwiesen,Träger zu verwenden, die Komponenten enthalten, die bereits bei der Sprühgranulation eingebracht wurden und zumindest teilweise temporären Charakter aufweisen. Es kann sich dabei um katalytisch wirkende Stoffe, wie Dotierungen von Fe und Ni handeln, die in Form ihrer Salze (beispielsweise als Nitratlösung) oder als metallorganische Verbindung ( beispielsweise als Carboxylate ) aufgebracht werden und / oder oder um kohlenstoff- oder kohlenwasserstoffhaltige Precursorkomponenten, die während der Diamantabscheidung als Kohlenstofflieferanten dienen oder um reaktive Elemente und Verbindungen handeln, die beispielsweise eine Anbindung der Diamantphase ( z.B. über eine Carbidbildung ) an den Träger bewirken.

Es hat sich als vorteilhaft erwiesen, die äußere und innere Oberfläche des Trägers vor der Abscheidung der synthetischen Diamantphase zu aktivieren. Die Aktivierung kann beispielsweise durch Einbringen der Träger in ein elektrisches Feld oder eine in halogenhaltige und / oder wasserstoffhaltige Atmosphäre erfolgen oder durch Anritzen mit einem bevorzugterweise diamanthaltigen Abrasivstoff oder durch Auslösen einer chemischen Reaktion wie z.B. Ausfällen von Salzen oder der Bildung von intermediären Carbiden. Bei einem SiO₂-Träger hat sich eine Silanisierung der Trägeroberfläche im Sinne einer Aktivierung bewährt.

Es hat sich als zweckmäßig erwiesen, im Einzelfall vor Abscheidung der Oberflächenschicht aus Diamantphase die Trägeroberfläche mit mindestens einer Zwischenschicht versehen werden. Die Zwischenschicht kann permanenter Natur sein, wie z.B. eine metallische Schicht zur Einkopplung von Energie oder eine carbidhaltige Schicht zur chemischen Anbindung oder eine Schicht zum Ausgleich von Wärmeausdehnungsunterschieden. Die Zwischenschicht kann aber auch temporärer Natur sein, analog der Komponente, die bereits dem Sprühgranulat zugesetzt ist. Eine temporäre Zwischenschicht kann beispielsweise in Form einer Lösung aufgebracht werden oder infiltriert werden. So kann z.B. eine katalytisch wirkende Zwischenschicht in Form einer Salzlösung oder in Form einer metallorganischen Verbindung aufgebracht werden. Es haben sich beispielsweise Nitratlösungen, Resinat und Carboxylate bewährt. Es hat sich gezeigt, daß bei der Abscheidung der Diamantphase auch kleine Mengen metallischer Komponenten wie Pd, Ru, Pt, Rh, Au oder Cr katalytisch wirksam sind, die bei der Diamant-Hochdrucksynthese keine Wirkung zeigen. Diese Gegebenheit ist vermutlich darauf zurückführbar, daß sich bei der Abscheidung aus der Gasphase die einzelnen Spezies im angeregten Zustand befinden. Die Zwischenschicht kann auch mehrphasig aufgebaut sein oder eine Doppelfunktion erfüllen, indem sie beispielsweise einen Kohlenstofflieferanten und eine katalytische Komponente enthält. Bei mit Porenkanälen versehenen Granulaten kann auch die innere Oberfläche (Wandungen der Porenkanäle) mit einer Zwischenschicht versehen werden.

Werden vor der eigentlichen Beschichtung der Oberfläche mit Diamantphase Zwischenschichten aufgebracht oder Reaktionen durchgeführt, kann es nützlich sein, eine Reaktionskammer einzusetzen, die in mehrere Abschnitte aufgeteilt ist, in denen die einzelnen Schichten aufgebracht werden oder die unterschiedlichen Reaktionen durchgeführt werden.

Es hat sich als nützlich erwiesen, daß zusammen mit dem Träger ein partikelförmiger Kohlenstofflieferant in den Reaktionsraum eingebracht wird. Es wird dabei Graphitpulver bevorzugt, da sich Graphit einfacher in Diamantphase umwandeln laßt als beispielsweise ein Kunststoff. Dies hat besonders bei der Abscheidung von Diamantphase mittels Laserplasma Gültigkeit.

Bei einer bevorzugten Variante erfolgt die Abscheidung der Diamantphase mittels einer Laserwellenlänge, für die Kohlenstoff in sp²-Bindug absorbierend und für Kohlenstoff in sp³-Bindung transparent ist. Dies hat den Vorteil, daß Kohlenstoff, der sp²-Bindung aufweist, selektiv abgesputtert wird, die bereits gebildete Diamantphase, die sp³-Bindung aufweist, jedoch erhalten bleibt. Die Ausbildung eines lokalen Laserplasmas kann durch Verwendung unterschiedlicher Gase beeinflußt werden.

Bei der Verwendung eines oxidationsbeständigen Trägers oder einer oxidationsbeständigen Zwischenschicht, wie SiC, AlN, AlON, Sialon, ZrO₂, Pt, Ir, Au, Rh oder SiO_{2,} kann die Abscheidung an Luft und bei Normaldruck durchgeführt werden.

Bei einer bevorzugten Prozeßvariante ist auch der Träger für die zur Anwendung kommenden Laserwellenlänge transparent. So ist beispielsweise glasiges SiO₂ hoher Reinheit für einen Nd:YAG-Laserstrahl transparent. Bei der Verwendung eines Nd:YAG-Laserstrahls kann unter Verwendung eines Reaktionsbehälters aus Quarzglas der Laserstrahl ohne Wechslwirkung durch die Wand des Behälters geführt werden und im Behälterinneren die Abscheidung von Diamantphase auf dem Träger vorgenommen werden.

Hinsichtlich des Komposits wird die Aufgabe erfindungsgemäß dadurch gelöst, daß der Träger sphärisch ausgebildet ist und eine eine spezifische Oberfläche von wenigstens 0,5 m²/g aufweist. Bei sehr kleinen Nano-Teilchen ( z.B. 5 nm ) wird eine spezifische Oberfläche von mehreren hundert m²/g für die Beschichtung zur Verfügung gestellt, daß sich ein sehr ökonomische Prozeß realisieren läßt, der hohe Abscheideraten ( in Karat pro Gramm ) zuläßt. Durch die sphärische Ausprägung lassen sich beim Einbringen in Kunststoffvergußmassen durch Ausbildung einer dichtesten Kugelpackung maximale Füllgrade erreichen, so daß sich die Teilchen allseitig berühren. Durch die Verwendung gleich großer, sphärischer Trägerteilchen ist eine nur gering Schwankung des Kompositdurchmessers realisierbar. Durch den hohen Gehalt an Diamantphase läßt sich eine bestmögliche Ableitung an Wärme von den elektonischen Komponenten erreichen, die in einer mit diesem Komposit gefüllten Vergußmasse eingebettet sind. Durch die sphärische Ausprägung des Trägers ist ein homogenes Wachstum der Oberflächenschicht aus Diamantphase gewährleistet, so daß keine wesentlichen Schichtdickenschwankungen auftreten und sich ein enges Kornverteilungsspektrum einstellt. Anstelle der wenigen Schneidkanten bei einem herkömmlichen, partikelförmigen Abrasiv, treten eine Vielzahl von Mikroschneiden, die in Form von Hunderten von Facetten in sphärischer, äquidistanter Anordnung ( vom Zentrum des Trägers aus gesehen ), auftreten. Es lassen sich mit dem erfindungsgemäßen Abrasivstoff höhere Oberflächengüten realisieren als mit einem konventionellen, da keine neuen Kratzer durch Polierrnittelbruch auftreten und von vomeherein ein sehr homogenes, enges Kornspektrum vorliegt. Nach Abtrag der Diamantphase der Oberflächenschicht ist immer noch Diamantphase in den Porenkanälen vorhanden, daß die Bearbeitung vor dem Körnungswechsel noch eine Zeit lang weitergeführt werden kann.
Das erfindungsgemäße Komposit kann auch eingebunden in der Matrix eines Abrasivwerkzeugs, wie beispielsweise einer Schleifscheibe oder in Form von Polier-Pellets, verwendet werden. Das Komposit ist außerden als Rohstoff für pulvertechnische Erzeugnisse einsetzbar. Je nach Wahl der Abscheidebedingungen läßt sich die Mikrostruktur der Oberfläche beeinflussen. Es lassen sich relativ glatte Oberflächen, wie gezielt mikrostrukturierte Oberflächen, als auch stark facettierte Oberflächen realisieren.

Bei einer bevorzugten Kompositvariante beträgt der Durchmesser des Trägers im Durchschnitt zwischen 10 nm und 10 µm und die Dicke der Oberflächenschicht aus synthetischer Diamantphase beträgt ein Vielfaches davon. Bei einem Komposit mit einem Trägerdurchmesser von 10 - 100 nm, wie er für pyrogen hergestellte Teilchen ( z.B. amorphes SiO₂ -Pulver ) typisch ist und einer Schichtdicke der Diamantphase von 5 µm ist das Volumen des Trägers gegenüber dem Volumen der Diamantphase vernachlässigbar klein, so daß das Komposit fast ausschließlich aus Diamantphase besteht. Dieses Komposit ist ideal als wärmeleitender Füllstoff für elektronische Anwendungen geeignet

Bei einer weiteren bevorzugten Kompositvariante sind Porenkanäle des Trägers mit synthetischer Diamantphase gefüllt und darüber ist eine geschlossene Diamantschicht ausgebildet. Es besteht damit eine ausgezeichnete mechanische wie auch chemische Anbindung der Diamantphase an den Träger, die zum einen durch die Verankerung der Diamantphase in den Porenkanälen, zum anderen in der kristallographischen Fortsetzung der Gitterstruktur des Diamanten besteht. Durch die weitestgehend durchgängige Diamantphase läßt sich eine ausgezeichnete Wärmeleitfähigkeit und eine hohe mechanische Belastbarkeit, wie auch chemische Beständigkeit erreichen. Der mittlere Durchmesser des aus einem sphärische Granulat gebildeten Trägers, liegt typischerweise zwischen 5 und 500 µm. Die Dicke der Oberflächenschicht aus Diamantphase liegt zweckmäßigerweise zwischen 2 und 500 µm. Für die kleinen Trägergranulate ( mittlere Durchmesser von 5 bis 50 µm ) werden zweckmäßigerweise als Primärteilchen Nano-Teilchen verwendet, wie sie in pyrolytischen Pulverherstellverfahren erzeugt werden. Gut geeignete Vertreter sind pyrolytisch hergestellte Teilchen aus SiO₂, ZrO₂, Al₂O₃, Diamant oder DLC ( diamond like carbon ). Für die größeren Trägergranulate ( 50 bis 500 µm ) werden als Primärteilche zweckmäßigerweise um-Teilchen ( z.B. über das Sol/Gel-Verfahren hergestellte Teilchen ) verwendet. Dieser Komposit eigner sich aufgrund seiner Eigenschaften besonders als Superabrasiv für eine Endbearbeitung ( Läppen oder Polieren ) zur Erzeugung eines Superfinish. Die feine Fraktion dieser Trägervariante ( 5-10 µm ) oder die noch feinere Kornfraktion aus dem Zyklon eignet sich als Träger für eine verbesserte Generation von Füllstoffen mit deutlich höherer Wärmeleitgähigkeit, wie eines deutlich verbesserten mechanischen Verstärkungseffekt als dies von herkömmliche Füllstoffen erreichbar ist.

Zwischen der Trägeroberfläche oder den Wandungen der Porenkanäle und der Deckschicht kann im einzelnen eine Zwischenschicht angeordnet sein.

Durch Verwendung eines amorphen Trägers läßt sich ein epitaktisches Mismatch vermeiden. Amorphes SiO₂ zeichnet sich durch besondere chemische Inertheit aus, ist temperatur- und oxidationsbeständig und besitzt für unterschiedliche Laserwellenlängen Transparez, so daß es sich zur Abscheidung von Diamantphase gut geeignet. Amorphes SiO₂ besitzt außerdem einen niedrigen Ausdehnungskoeffizienten.

Ein Träger aus pyrogen hergestelltem Diamantpulver oder aus nanoskaligem DLC ( diamond like carbon ) ist aus chemischer und kristallographischer Sicht ein idealer Trägerwerkstoff. Besondere ökonomische Vorteile bietet ein sprühgranulierter Träger, der aus nano-skaligen Diamant- oder DLC-Primärteilchen besteht. Die Herstellung nano-skaliger Primärteilchen aus Diamant oder DLC erfolgt analog dem Verfahren zur Herstellung pyrogener Pulverteilchen z.B. der pyrogenen Kieselsäure. Die verfahrenstypisch hohe spezifische Oberfläche bleibt während der Sprühgranulation erhalten. Es lassen sich auf diesem Träger hohe Abscheideraten ( in Karat pro Zeiteinheit ) erreichen, da eine große spezifische Oberfläche zur Verfügung steht.

Der zumindest teilweise mit Diamantphase versehene Träger oder das fertige Komposit ist in aufgeschütteter Form zur Rundumbeschichtung von in die Schüttung eingebrachten Formteilen, stückigen Diamanten oder Diamantsplittern oder zur Beschichtung von Schmucksteinen mit Diamantphase geeignet. Zur Beschichtung in der Hilfsschüttung geeignet sind vorallem kleine Teile, die jedoch deutlich größere Geometrien aufweisen als das partikelförmige Komposit. Es kann von Vorteil sein, die mittlere Dichte des Komposits höher zu wählen als die des zu beschichtenden Formteils, da hierbei der Effekt des Aufschwimmens der Formteile auftritt, der prozeßtechnisch genutzt werden kann.

Bei dem zu beschichtenden Formteil kann es sich beispielsweise um ein Keramiksubstrat ( z.B. aus AlN, SiC oder Al₂O₃ handeln ) oder auch um ein Metall-Substrat ( Cu, Stahl ). Es kann sich auch um stückige Diamanten oder Splitter davon handeln, die vergrößert werden sollen. Da viele Schmucksteine nur eine geringe Härte aufweisen, und damit eine geringe Kratzfestigkeit besitzen, hat sich der Einsatz der beschriebenen Hilfsschüttung aus Komposit-Teilchen zur kratzfesten oder auch dekorativen Beschichtung von Schmucksteinen mit einer Oberflächenschicht aus Diamantphase bewährt.

In der Schüttung lassen sich Kleinteile sehr schonend mit Diamantphase beschichten. Die Schüttung aus Komposit-Teilchen wirkt auf die zu beschichtenden Formteile auch im Sinne einer mechanischen Aktivierung.

Anhand von Ausführungsbeispielen wird nachfolgend die Erfindung näher erläutert.

In der Patentzeichnung zeigen
Figur 1: ein Komposit, bestehend aus einem Täger aus einem Sprühgranulat mit einem mit Diamantphase gefüllten Porenraum und einer daran allseitig anschließenden Deckschicht aus Diamantphase
Figur 2: ein Komposit mit einem Träger aus pyrogener Kieselsäure mit einer darauf aufgebrachten Oberflächenschicht aus DiamantphaseFigur 3: ein Komposit, bestehend aus einem Träger, einer Zwischenschicht und einer Oberflächenschicht aus Diamantphase

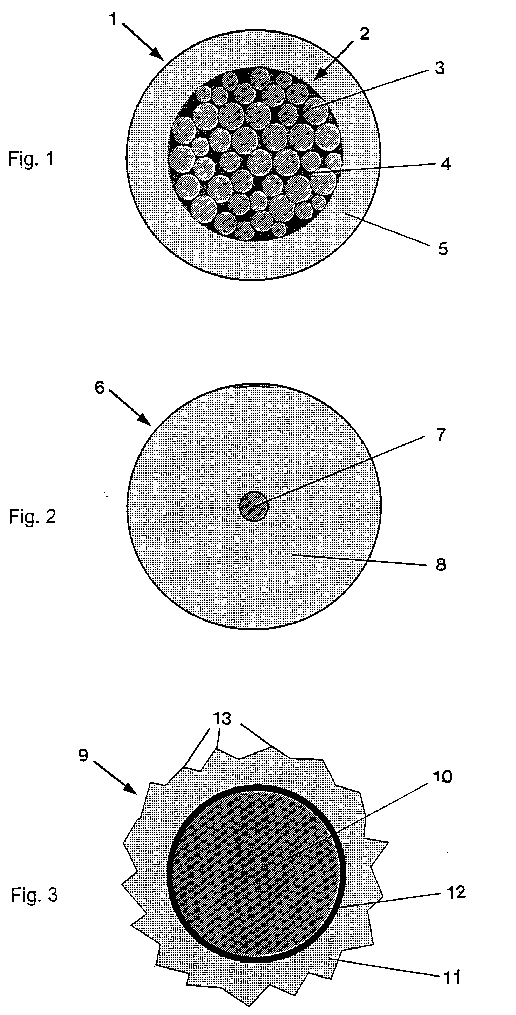

Nachfolgend wird das erfindungsgemäße Verfahren zur Beschichtung von partikelförmigen Trägern anhand der Darstellungen in den Figuren 1 bis 3 näher erläutert.

Fig. 1 zeigt in schematischer Darstellung ein Komposit 1 mit einem Träger 2 aus einem Sprühgranulat, das aus einer Vielzahl sphärischer Teilchen 3 aus pyrogenem Al₂O₃ mit einem mittleren Durchmesser von 15 nm aufgebaut ist und in sich einen Durchmesser von 40 µm aufweist. Die durchgehenden Porenkanäle 4 sind mit Diamantphase gefüllt, die aus Gründen einer deutlichen Darstellung mit einer anderen Schraffur versehen ist als die Diamantphase der Oberflächenschicht. Tatsächlich besteht eine mechanische und chemische Anbindung der Diamantphase der Oberflächenschicht der Diamantphase in den Porenkanälen. Über dem Träger 2, bestehend aus pyrogenem Al₂O₃ und Diamantphase, ist eine 8 µm dicke, allseitig geschlossene Oberflächenschicht aus Diamantphase 5 aufgebracht. Die Oberfläche der äußeren Diamantschicht weist eine mikrokristalline Struktur auf, die jedoch in der Fig.1 nicht dargestellt ist. Dieses Komposit ist besonders als Abrasivstoff zum Präzissionsschleifen oder zur Feinstbearbeitung geeignet.

Fig. 2 zeigt ein Komposit 6, das als Träger ein sphärisches SiO₂-Teilchen aufweist, das einen Durchmesser von von 0,5 µm aufweist und nach dem Sol/Gel-Verfahren hergestellt wurde. Die darauf abgeschiedene Diarnantschicht 8 hat eine Dicke von 20 µm. Das Volumen des weniger gut wärmeleitenden Trägers ist damit gegenüber der gut wärmeleitenden Diamantphase vernachlässigbar klein, weil das Komposit fast ausschließlich aus Diamantphase besteht. Diese Komposit ist als wärmeleitender Füllstoff ausgezeichnet geeignet. Es eignet sich aber auch zur Weiterverarbeitung zu pulvertechnischen Produkten geeignet.

Fig. 3 zeigt ein dreiphasig aufgebautes Komposit 9. Das Komposit besteht aus einem Träger 10 aus reinem Si, das mittels Plasmaverdüsung hergestellt wurde und einen mittleren Teilchendurchrnesser von 5 µm und eine spezifische Oberfläche von 0,8 m²/g aufweist. Zur besseren Anbindung der Diamantphase 11 ist der Träger mit einer 0,1 µm dicken SiC-Schicht 12 versehen. Die Oberfläche der Diamantschicht weist eine Vielzahl von Wachstumsfacetten 13 auf. Die schematisch dargestellten Wachstumsfacetten 13 fungieren als Mikroschneiden. Dieses Komposit eignet sich als Abrasivstoff entweder in loser Form oder eingebunden in die Matrix eines Abrasivwerkzeuges zur Erzeugung eines Superfinish auf den zu bearbeitenden Werstückoberflächen. Das beschriebene Komposit bietet besondere Vorteile bei der Endbearbeitung von Si-Wafern, wo höchste Oberflächengüten und Reinheiten erforderlich sind. Nach Abtrag der Diamantschicht wird nur der mit den Si-Wafern artgleiche Träger, nämlich reines Si frei.

Nachfolgend wird anhand von drei Ausführungsbeispielen das Verfahren zur Beschichtung partikelförmiger Träger näher erläutert.

### Beispiel 1

100 g sphärische Trägerteilchen aus Si mit einem mittleren Durchmesser von 10 µm werden dem rohrförmigen, aus Quarzglas gebildeten Reaktionsgefäßes eines Mikrowelenplasma-Reaktors von 1 KW und 2,45 GHz fluidisiert. Das obere Niveau der fluidisierten Trägerteilchen tritt dabei jeweils in in das induktiv eingekoppelte Plasma ein. Das Reaktionsgas hat eine Zusammensetzung von 99,7 Vol% H₂, 0,3Vol% CH₄. Beim Eintritt der Teilchen des oberen Fluidisierungsniveaus in das Plasma tritt jeweils Beschichtung ein. Durch die laufende Umwälzung und das Eintauchen der Teilchen in die Plasmazone werden die Teilchen schließlich gleichmäßige rundherum beschichtet. Nach Abscheidung einer 10 µm dicken Diamantschicht werden die aus Silizium und der Diamantschicht bestehenden Komposit-Teilchen mittels einer Absaugvorrichtung ausgetragen.

### Beispiel 2

Es werden 5 g sphärische SiO₂-Teilchen zusammen mit 1 g Graphit-Teilchen in ein Quarzglasgefäß eingebracht. Zur Abscheidung wurde wurd ein Nd:YAG-Laser mit einer Wellenlänge von 1064 nm, einer Laserleistung von 5 KW und einer Pulsenergie von 50 J, verwendet. In unmittelbarer Nähe des Graphits scheiden sich bereits bei einem einzelnen Impuls einer Impulsdauer von 8 msec und einer Pulsenergie von 40 J, unter Ausbildung eines lokalen Plasmas, Tausende Diamantkristallkristalle mit Abmessungen von 0,3 - 0,6 nm ab. Die Kristalle weisen einen ausgeprägten Habitus auf und berühren sich zum Teil. Bei Fortsetzung der Behandlung wachsen die Kristallite zu einer geschlossenen Diamantschicht zusammen.

### Beispiel 3

In einem weiteren Ausführungsbeispiel werden sprühgranulierte DLC-Teilchen analog dem Ausführungsbeispiel 1 dem Mikrowellenplasma zur Diamantbeschichtung ausgesetzt.

## Patentansprüche

1. Verfahren zur Beschichtung eines Trägers mit einer Oberflächenschicht aus synthetischer Diamantphase durch Bereitstellen und Einbringen eines Trägers in eine kohlenstoffhaltige, im angeregten Zustand befindliche Gasphase und Abscheiden einer Oberflächenschicht aus synthetischer Diamantphase auf dem Träger, wobei eine Vielzahl partikelförmig ausgebildeter Träger aufgeschüttet werden und die Träger während der Abscheidung einer allseitig geschlossenen Oberflächenschicht, einer translatorischen und einer Rotationsbewegung ausgesetzt werden, dadurch gekennzeichnet, daß die Träger sphärisch ausgebildet sind und eine spezifische Oberfläche von mindestens 0,5 m²/g aufweisen.

2. Verfahren nach Anspruch 1, dadurch gekennzeichnet, daß die Träger mittels Sprühgranulation hergestellt sind, bei der unter Beibehaltung der spezifischen Oberfläche sphärische Aggregate mit durchgehenden Porenkanälen ausgebildet werden.

3. Verfahren nach Anspruch 2, dadurch gekennzeichnet, daß bei der Sprühgranulation Komponenten eingebracht werden, die temporäre Eigenschaften aufweisen.

4. Verfahren nach den Ansprüchen 1 bis 3, dadurch gekennzeichnet, daß die Oberfläche der Träger vor der Abscheidung der Oberflächenschicht aktiviert wird.

5. Verfahren nach den Ansprüchen 1 bis 4, dadurch gekennzeichnet, daß die Träger vor Abscheidung der Oberflächenschicht mit mindestens einer Zwischenschicht versehen werden.

6. Verfahren nach einem der Ansprüche 1 bis 5, dadurch gekennzeichnet, daß vor der Abscheidung der Oberflächenschicht, Porenkanäle des Trägers mit synthetischer Diamantphase gefüllt werden.

7. Verfahren nach einem der Ansprüche 1 bis 6, dadurch gekennzeichnet, daß zusammen mit dem Träger ein partikelförmiger Kohlenstofflieferant in den Reaktionsraum eingebracht wird.

8. Verfahren nach einem der Ansprüche 1 bis 7, dadurch gekennzeichnet, daß die Abscheidung der Diamantphase mittels eines Laserplasmas erfolgt.

9. Verfahren nach Anspruch 8, dadurch gekennzeichnet, daß die Abscheidung mittels einer Laserwellenlänge erfolgt, für die Kohlenstoff in sp²-Bindung absorbierend und für Kohlenstoff in sp³-Bindung transparent ist.

10. Verfahren nach Anspruch 8 oder 9, dadurch gekennzeichnet, daß die Abscheidung mittels einer Wellenlänge erfolgt, für die der Träger transparent ist.

11. Komposit aus einem Träger mit einer Oberflächenschicht aus synthetischer Diamantphase, wobei der Träger partikelförmig ausgebildet ist und allseitig mit einer Oberflächenschicht aus synthetischer Diamantphase versehen ist, dadurch gekennzeichnet, daß der Träger sphärisch ausgebildet ist und eine spezifische Oberfläche von wenigstens 0,5 m²/g aufweist.

12. Komposit nach Anspruch 11, dadurch gekennzeichnet, daß der Träger einen mittleren Durchmesser von 10 nm bis 10 µm aufweist, und daß die Dicke der Oberflächenschicht aus Diamantphase ein Vielfaches davon beträgt.

13. Komposit nach Anspruch 11, dadurch gekennzeichnet, daß Porenkanäle des Trägers mit synthetischer Diamantphase gefüllt sind und darüber eine geschlossene Oberflächenschicht aus Diamantphase ausgebildet ist, wobei der mittlere Durchmesser des Trägers zwischen 5 und 500 µm und die Dicke der Oberflächenschicht zwischen 1 und 500 µm liegt.

14. Komposit nach einem der Ansprüche 11 bis 13, dadurch gekennzeichnet, daß der Träger aus amorphem SiO₂ besteht.

15. Komposit nach einem der Ansprüche 11 bis 14, dadurch gekennzeichnet, daß der Träger aus nano-skaligem Diamant- oder DLC-Pulver besteht.

16. Verwendung des zumindest teilweise mit Diamantphase versehenen Trägers oder des fertigen Komposits in aufgeschütteter Form zur Rundumbeschichtung von in die Schüttung eingebrachten kleinen Formteilen, stückigen Diamanten oder Diamantsplittern oder zur Beschichtung von Schmucksteinen mit Diamantphase.
